Europäisches Patentamt

European Patent Office

Office européen des brevets

(11) Veröffentlichungsnummer: **0 410 255 A2**

# EUROPÄISCHE PATENTANMELDUNG

(21) Anmeldenummer: 90113580.6

(22) Anmeldetag: **16.07.90**

(51) Int. Cl.5: **G01R 19/165**

(30) Priorität: **25.07.89 DE 3924603**

(43) Veröffentlichungstag der Anmeldung:
**30.01.91 Patentblatt 91/05**

(84) Benannte Vertragsstaaten:
**AT CH DE DK ES FR GB IT LI NL**

(71) Anmelder: **Siemens Aktiengesellschaft**
**Wittelsbacherplatz 2**
**D-8000 München 2(DE)**

(72) Erfinder: **Scharfenberg, Goerge, Prof.**
**Schernrieder Strasse 26**
**D-8411 Laaber(DE)**

(54) **Schaltung zur signaltechnisch sicheren Bewertung einer Gleichspannung.**

(57) Es sind zwei baugleiche Komparatoren (K1, K2) vorgesehen, von denen dem einen (K1) auf seinem einen Eingang (+) die zu bewertende Spannung ($U_E$) und auf seinem anderen Eingang (-) eine konstante Referenzspannung ($U_R$) zugeführt sind, während bei dem anderen (K2) die Zuordnung der Spannungen ($U_E$, $U_R$) zu den Eingängen ( +, -) vertauscht ist. Die Referenzspannung ($U_R$) ist dabei die Spannung, deren Unter- oder Überschreiten durch die zu bewertende Spannung ($U_E$) anzuzeigen ist. Die Ausgänge der Komparatoren sind als open-collector-Ausgänge ausgebildet. Der Ausgang des einen Komparators (K2) ist auf den wahren, der Ausgang des anderen Komparators (K1) ist auf den negierenden Eingang eines NOR-Gliedes (T) geführt, das an seinem Ausgang (A) dann ein eine Störung kennzeichnendes Meeldesignal (MS) abgibt wenn die zu bewertend Spannung ($U_E$) die Referenzspannung ($U_R$) unter- bzw. überschreitet oder wenn die Schaltung aufgrund fehlerhafter Bauelemente oder aufgrund unzulässiger Spannungsabsenkungen der Versorgungsspannung (U) nicht mehr ordnungsgerecht arbeitet. Die erfindungsgemäße Schaltung ist besonders geeignet für die Ausgabe von Rechnerdaten, indem sie diese in ihrer Amplitude bewertet und Störungen infolge von Spannungseinbrüchen der Rechnerstromversorgung ausblendet.

FIG 1

## SCHALTUNG ZUR SIGNALTECHNISCH SICHEREN BEWERTUNG EINER GLEICHSPANNUNG

Die Erfindung bezieht sich auf eine Schaltung nach dem Oberbegriff des Patentanspruches 1.

Eine solche Schaltung ist aus der DE-AS 2 247 776 bekannt. Bei dieser bekannten Schaltung wird die zu bewertende Gleichspannung dem einen und eine den zu detektierenden Grenzwert dieser Spannung vorgebende Referenzspannung dem anderen Eingang eines Operationsverstärkers zugeführt, der abhängig von der Zuordnung der beiden Spannungen zu seinen beiden Eingängen an seinem Ausgang dann ein Alarmsignal abgibt, wenn die zu bewertende Gleichspannung entweder niedriger oder höher ist als die den Grenzwert vorgebende Referenzspannung. Diese bekannte Schaltung arbeitet nach dem Arbeitsstromprinzip, das heißt, ihr Funktionsverhalten ist bei ordnungsgerechter Amplitude der zu bewertenden Spannung nicht überwacht. Damit besteht auch keine Gewähr dafür, daß die Schaltung im Störungsfall ordnungsgerecht arbeitet. Das Schaltverhalten der Schaltung ist darüber hinaus abhängig vom Vorhandensein einer ausreichend hohen Versorgungsspannung für die Schaltung. Unterschreitet diese Spannung einen kritischen Grenzwert, so ist für die Dauer der Grenzwertunterschreitung eine sichere Störungskennzeichnung nicht mehr gegeben; insbesondere dort, wo die Schaltung an der zu überwachenden Stromversorgung betrieben wird, sind Fehlreaktionen zu erwarten.

Aufgabe der Erfindung ist es, eine Schaltung zur signaltechnisch sicheren Bewertung einer Gleichspannung hinsichtlich ihrer Amplitude anzugeben, die insbesondere auch dann noch einwandfreie Meldesignale liefert wenn die Versorgungsspannung der Schaltung unter einen kritischen Grenzwert absinkt.

Die Erfindung löst diese Aufgabe durch die kennzeichnenden Merkmale des Patentanspruches 1. Vorteilhafte Ausgestaltungen und Weiterbildungen der erfindungsgemäßen Schaltung sind in den Un teransprüchen 2 bis 5 angegeben. Der Unteranspruch 6 benennt eine vorteilhafte Verwendung der erfindungsgemäßen Schaltung bei der Ausgabe binärer Daten, insbesondere der Ausgabe von Rechnerdaten. Diese Verwendung der erfindungsgemäßen Schaltung verhindert, daß beim An- und Abschalten von Rechnern bzw. bei Störungen in der Rechner-Stromversorgung die dabei am Ausgang eines Rechners möglicherweise auftretenden störbehafteten Signale als Rechnertelegramme in nachfolgende Verarbeitungseinrichtungen eingelesen werden.

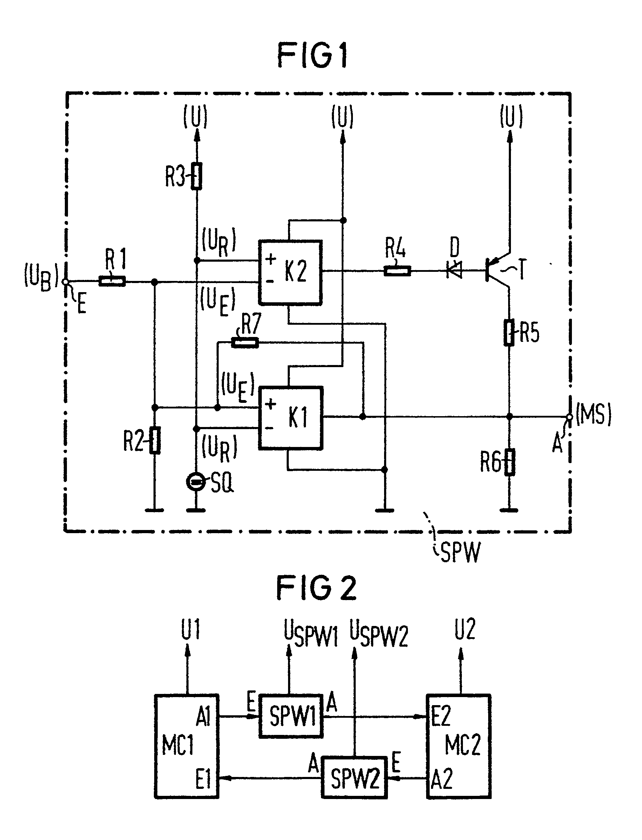

Die Erfindung ist nachstehend anhand eines in der Zeichnung dargestellten Ausführungsbeispieles näher erläutert. Die Zeichnung zeigt in Figur 1 den Aufbau der erfindungsgemäßen Schaltung und in Figur 2 die Anwendung der Schaltung bei zwei miteinander gekoppelten Rechnern.

Der in Figur 1 dargestellte Spannungswächter SPW weist einen Eingang E für die zu bewertende Spannung $U_B$ und einen Ausgang A für dort abgreifbare Meldesignale MS auf. Die Bezeichnungen für Spannungen und Meldesignale sind im Gegensatz zu den Bezeichnungen für Bauelemente in Figur 1 in Klammern gesetzt. Die zu bewertende Gleichspannung $U_B$, die aus einer Wechselspannung abgeleitet sein kann, wird im Spannungswächter SPW einem Spannungsteiler aus den Widerständen R1 und R2 zugeführt. Der Spannungsteiler dient zur Anpassung der zu bewertenden Gleichspannung $U_B$ an eine dem Spannungswächter fest eingeprägte oder ihm zugeführte Referenzspannung $U_R$. Diese Referenzspannung $U_R$ ist in Fig. 1 am Ausgang einer über einen hochohmigen Widerstand R3 betriebenen Konstantspannungsquelle SQ abgreifbar. Der Abgriff des Spannungsteilers R1, R2 ist so gewählt, daß die dort anliegende Spannung $U_E$ genau der Referenzspannung $U_R$ entspricht, wenn die zu bewertende Gleichspannung $U_B$ ihren gerade noch zulässigen niedrigsten Amplitudenwert aufweist. Im nachfolgenden wird die aus der zu bewertenden Gleichspannung $U_B$ abgeleitete Gleichspannung $U_E$ als zu bewertende Gleichspannung bezeichnet. Die zu bewertende Gleichspannung $U_E$ ist dem einen Eingang eines Komparators K2 zugeführt, an dessen anderem Eingang die Referenzspannung $U_R$ anliegt. Es ist ein weiterer baugleicher Komparator K1 vorgesehen, bei dem die Zuordnung der beiden Spannungen zu den Komparator eingängen vertauscht ist. Beide Komparatoren liegen an einer Versorgungsspannung U. Diese Versorgungsspannung kann, muß jedoch nicht identisch sein mit der zu bewertenden Gleichspannung $U_B$, das heißt, in diesem Falle würde der Spannungswächter SPW an der zu überwachenden Stromversorgung betrieben werden. Die Ausgänge der beiden Komparatoren K1 und K2 sind als open-collector-Ausgänge ausgeführt, die dann und nur dann niederohmig gegen Bezugspotential sind, wenn die an ihrem durch ein Pluszeichen gekennzeichneten einen Eingang anliegende Spannung niedriger ist als die an ihrem durch ein Minuszeichen gekennzeichneten anderen Eingang anliegende Spannung. Dies bedeutet, daß die beiden Komparatoren mindestens dann, wenn die zu bewertende Spannung $U_E$ verschieden ist von der Referenzspannung $U_R$ und eine ausreichende Versorgungsspannung U vorhanden ist, an ihrem Ausgang antivalente Signale führen. Solange die zu bewertende Gleichspannung $U_E$ größer ist als die Referenzspannung $U_R$, ist der Ausgang des Komparators K2 niederohmig und steuert über einen Widerstand R4 und eine Sperrdiode D einen nachgeschalteten pnp-Transistor T in den niederohmigen Schaltzustand. Dieser Transistor liegt mit seinem Emitter an einer Versorgungsspannung U und mit seinem Collector über einen Widerstand R5 am Ausgang des Komparators K1. Dieser Ausgang ist mit dem Ausgang A des Spannungswächters und über einen Widerstand R6 mit dem Minuspol der VersorgungsSpannung U verbunden.

Unter der Annahme, daß die zu bewertende Gleichspannung $U_E$ größer ist als die Referenzspannung $U_R$, ist der Ausgang des Komparators K1 hochohmig, so daß bei durchgesteuertem Transistor am Ausgang A des Spannungswächters ein aus der Betriebsspannung U des Transistors T abgeleitetes Meldesignal MS als Zeichen für eine ausreichende Amplitude der zu bewertenden Gleichspannung $U_B$ abgreifbar ist.

Sinkt die zu bewertende Gleichspannung $U_B$ am Eingang des Spannungswächters soweit ab, daß die aus ihr abgeleitete Spannung $U_E$ die Referenzspannung $U_R$ unterschreitet, so werden der Ausgang des Komparators K1 niederohmig und der Ausgang des Komparators K2 hochohmig. Der Komparator K1 legt dann Bezugspotential an den Ausgang A des Spannungswächters; das dort abgreifbare Meldesignal MS signalisiert die eingetretene Störung.

Der Transistor verknüpft die Ausgangssignale der beiden Komparatoren nach einer NOR-Verknüpfung. Das am Ausgang des Spannungswächters abgreifbare Meldesignal MS ist abhängig vom Betriebsverhalten beider Komparatoren. Fällt einer der Komparatoren aus irgendeinem Grunde aus, so kennzeichnet das am Ausgang A des Spannungswächters abgreifbare Meldesignal die eingetretene Störung durch ein Fehlersignal, das gleichbedeutend ist mit einer als zu niedrig erkannten zu bewertenden Gleichspannung. Ist beispielsweise der Ausgang des Komparators K1 störungsbedingt niederohmig, obgleich die zu bewertende Spannung größer ist als die Bezugsspannung, so wird der Ausgang A des Spannungswächters auf Bezugspotential gezogen; Bezugspotential am Ausgang A des Spannungswachters aber kennzeichnet den Störungsfall. Ist der Ausgang des Komparators K2 störungsbedingt niederohmig, obgleich die zu überwachende Gleichspannung $U_E$ niedriger ist als die Referenzspannung $U_R$, so wird zwar der Transistor T durchgesteuert; da in diesem Fall aber auch der Ausgang des Komparators K1 niederohmig ist und den Ausgang A des Spannungswächters auf Bezugspotential zieht, ist die eingetretene Störung über das am Ausgang A abgreifbare Meldesignal erkennbar.

Die beiden Komparatoren müssen baugleich ausgeführt sein, um sicherzustellen, daß sie gleiches Schaltverhalten aufweisen. Vorzugsweise sind die beiden Komparatoren Bestandteil eines gemeinsamen integrierten Schaltkreises. Diese Maßnahme garantiert, daß die an der gleichen Versorgungsspannung U liegenden Komparatoren in gleicher Weise auf etwaige Spannungseinbrüche der Versorgungsspannung reagieren, was bedeutet, daß die Antivalenz an ihren Ausgängen dann aufgehoben ist und am Ausgang A des Spannungswächters ein die Störung kennzeichnendes Meldesignal abgreifbar ist. Die Beschaltung der Komparatoren mit open-collector-Ausgängen ist Voraussetzung für NOR-Verknüpfung ihrer Ausgangssignale.

Der Ausgang des Komparators K1 ist mit demjenigen Komparatoreingang, an dem die zu bewertende Spannung $U_E$ anliegt, über einen Mitkopplungswiderstand R7 hochohmig verbunden. Über diese Mitkopplung wird eine ausgeprägte Schaltcharakteristik des Komparators auch bei nahezu übereinstimmenden Eingangsspannungen $U_E$ und $U_R$ erreicht.

Sobald die zu bewertende Eingangsspannung $U_E$ die Referenzspannung $U_R$ geringfügig unterschreitet und der Ausgang des Komparators K1 niederohmig wird, wird die seinen Eingang zugeführte zu bewertende Spannung $U_E$ durch den Widerstand R7 abgesenkt und damit die Spannungsdifferenz an den Eingängen des Komparators vergrößert.

Die vorstehend beschriebene Schaltung zur signaltechnisch sicheren Bewertung einer Gleichspannung kann auch dazu verwendet werden, um das Überschreiten vorgegebener Spannungsschwellwerte erkennbar zu machen. Es sind in diesem Falle die Zuordnungen der zu bewerten den Gleichspannung und der Referenzspannung zu den Eingängen der beiden Komparatoren zu vertauschen. Die Wirkung dabei ist die, daß dann die Referenzspannung die Funktion der vorstehend erläuterten zu bewertenden Spannung und die zu bewertende Spannung die Funktion der Referenzspannung übernimmt, das heißt, der Spannungswächter überprüft, ob die Referenzspannung stets größer ist als die zu bewertende Spannung.

Figur 2 zeigt die Anwendung der erfindungsgemäßen Schaltung bei einem aus zwei Rechnern MC1 und MC2 bestehenden Rechnersystem, deren Einzelrechner Daten untereinander auszutauschen haben. An den Rechnerausgang A1 des Rechners MC1 ist der Eingang E eines ersten Spannungswächters SPW1 angeschlossen. Dieser Spannungswächter schaltet die vom Ausgang A1 des Rechners MC1 abgegebenen Signale nur dann auf seinen Ausgang A, wenn die Versorgungsspannung U1 des Rechners MC1 und damit auch die abgegebenen Signale eine bestimmte Mindestamplitude aufweisen. Auf diese Weise wird verhindert, daß beim Absinken oder Abschalten der Versorgungsspannung U1 des Rechners MC1 am Ausgang A1 des Rechners oder beim Absinken oder Abschalten der Versorgungsspannung $U_{SPW1}$ des Spannungswächters SPW1 auftretende unkontrollierte Signale als Telegramm über den Eingang E2 in den Rechner MC2 eingelesen werden können. In entsprechender Weise verhindert ein zweiter Spannungswächter SPW2, daß am Ausgang A2 des Rechners MC2 bei Spannungseinbrüchen in der Stromversorgung oder beim Absinken oder Abschalten der Versorgungsspannung $U_{SPW2}$ des Spannungswächters SPW2 auftretende Impulse über den Eingang E1 in den Rechner MC1 eingelesen werden können. Die Verwendung der erfindungsgemäßen Schaltung zur Ausgabe von Rechnerdaten ist besonders geeignet bei der Kopplung von an unterschiedlichen Stromversorgungen liegenden Rechnern, bei denen beim Auftreten von Störungen nur einer oder einige Rechner von der Störung direkt betroffen sind, andere nicht. Bevorzugt wird die Stromversorgung des jeweils sendenden Rechners, z. B. MC1, für die Versorgung des die Signale dieses Rechners bewertenden Spannungswächters SPW1 gemeinsam verwendet, d. h. $U_{SPW1}$ = U1 und $U_{SPW2}$ = U2. Die erfindungsgemäße Schaltung läßt sich mit Vorteil auch bei aus einer größeren Anzahl von Einzelrechnern bestehenden Rechnersystemen anwenden, bei denen die Ausgänge der den Rechnern zugeordneten Spannungswächter auf ein gemeinsames Bussystem geführt sind.

**Ansprüche**

1. Schaltung zur signaltechnisch sicheren Bewertung einer Gleichspannung hinsichtlich ihrere Amplitude durch Vergleich mit einer Referenzspannung und Ausgabe eines Meldesignals, wenn die zu überwachende Gleichspannung die Referenzspannung unterschreitet/überschreitet ,
**dadurch gekennzeichnet,** daß zwei baugleiche Komparatoren (K1, K2) vorgesehen sind, von denen dem einen (K1) auf seinem einen ( + )/anderem Eingang die zu bewertende Gleichspannung ($U_E$) und auf seinem anderen (-) einen Eingang die Referenzspannung ($U_R$) zugeführt sind, während diese Zuordnung bei dem anderen Komparator (K1) vertauscht ist, daß die Ausgänge der beiden Komparatoren als open-collector-Ausgänge ausgeführt sind, die dann und nur dann niederohmig gegen Bezugspotential sind, wenn die an ihrem einen Eingang ( + ) anliegende Spannung niedriger ist als die an ihrem anderen Eingang (-) anliegende Spannung
und daß der Ausgang des einen Komparators (K2) auf den wahren Eingang und der Ausgang des anderen Komparators (K1) auf den invertierenden Eingang eines das Meldesignal (MS) ausgebenden NOR-Gliedes geführt sind.

2. Schaltung nach Anspruch 1, **dadurch gekennzeichnet,** daß die beiden Komparatoren (K1, K2) Bestandteil eines gemeinsamen integrierten Schaltkreises sind.

3. Schaltung nach Anspruch 1, **dadurch gekennzeichnet,** daß das NOR-Glied aus einem pnp-Transistor (T) besteht, dessen Basis am Ausgang des einen Komparators (K2), dessen Collector am Ausgang des anderen Komparators (K1) und dessen Emitter an einer Versorgungsspannung (U) liegt.

4. Einrichtung nach Anspruch 1, **dadurch gekennzeichnet,** daß eine Mitkopplung zwischen dem Ausgang des einen Komparators (K1) und demjenigen Eingang ( + ) dieses Komparators vorgesehen ist, an dem die zu bewertende Gleichspannung ($U_E$)/die Referenzspannung ($U_R$) anliegt.

5. Schaltung nach Anspruch 1, **dadurch gekennzeichnet,** daß die Stromversorgung der Komparatoren (K1, K2) jeweils aus der gleichen Spannungsquelle erfolgt, welche die zu bewertende Spannung ($U_B$) liefert.

6. Verwendung der Schaltung nach mindestens einem der vorangehenden Ansprüche zur Ausgabe binärer Daten, **dadurch gekennzeichnet,** daß die binären Daten der Schaltung als zu bewertende Gleichspannung zugeführt sind und daß die Meldesignale der Schaltung für nachfolgende Verarbeitungseinrichtungen die binären Daten bilden.

## FIG 1

## FIG 2